# EUROPÄISCHE PATENTANMELDUNG

(11) **EP 2 966 489 A1**
(43) Veröffentlichungstag der Anmeldung: **13.01.2016**
(21) Anmeldenummer: 15173788.9
(22) Anmeldetag: 25.06.2015
(51) Int. Cl.: G02B 13/14, G03F 7/20

(54) **BELEUCHTUNGSOPTIK SOWIE ABBILDENDE OPTIK FÜR EIN METROLOGIESYSTEM FÜR DIE UNTERSUCHUNG EINES OBJEKTS MIT EUV-BELEUCHTUNGS- UND ABBILDUNGSLICHT SOWIE METROLOGIESYSTEM MIT EINER DERARTIGEN BELEUCHTUNGSOPTIK BZW. EINER DERARTIGEN ABBILDUNGSOPTIK**

(30) Priorität: 30.06.2014 DE 102014212568
(71) Anmelder: Carl Zeiss SMT GmbH, 73447 Oberkochen (DE)
(72) Erfinder: Kneer, Bernhard, 89605 Altheim (DE); Neumann, Jens Timo, 73434 Aalen (DE); Mann, Hans-Jürgen, 73447 Oberkochen (DE)
(74) Vertreter: Carl Zeiss AG - Patentabteilung

(57) **Zusammenfassung**

Ein Metrologiesystem (2) dient zur Untersuchung eines Objekts (5) mit EUV-Beleuchtungs- und Abbildungslicht (1). Eine Beleuchtungsoptik (7) für das Metrologiesystem (2) hat eine im Strahlengang vor dem Objekt (5) angeordnete Beleuchtungs-Aperturblende (11) zur randseitigen Begrenzung eines Bündels des Beleuchtungslichts (1). Die Beleuchtungs-Aperturblende (11) hat in einer Blendenebene (xy) in zwei zueinander senkrechten Richtungen zwei sich voneinander um mindestens 10 % unterscheidende Blendendurchmesser. Eine abbildende Optik (13) hat eine im Strahlengang nach dem Objekt (5) angeordnete Abbildungs-Aperturblende (15) zur randseitigen Begrenzung eines Bündels des Abbildungslichts (1). Die Abbildungs-Aperturblende (15) hat in einer Blendenebene (xy) in zwei zueinander senkrechten Richtungen zwei sich voneinander um mindestens 10 % unterscheidende Blendendurchmesser (Bx, By). Es resultiert ein Metrologiesystem, dessen Optiken an die bei der anamorphotischen Projektionsbelichtung zur Herstellung von Halbleiterbauelementen vorliegenden Beleuchtungs- und Abbildungsverhältnisse angepasst sind.

## Beschreibung

Die Erfindung betrifft eine Beleuchtungsoptik für ein Metrologiesystem für die Untersuchung eines Objekts mit EUV-Beleuchtungs- und Abbildungslicht. Ferner betrifft die Erfindung eine abbildende Optik für ein derartiges Metrologiesystem, ein Metrologiesystem mit einer derartigen Beleuchtungsoptik und ein Metrologiesystem mit einer derartigen abbildenden Optik.

Metrologiesysteme der eingangs genannten Art sind bekannt aus der US 2013/0063716 A1, der DE 102 20 815 A1, der DE 102 20 816 A1 und aus der US 2013/0083321 A1. Aus der EP 2 506 061 A1 ist eine Projektionsoptik für eine Projektionsbelichtungsanlage zur Herstellung von Halbleiterbauelementen bekannt, die eine Aperturblende einsetzt, bei der der Blendendurchmesser in zwei zueinander senkrechten Richtungen sich um mehr als 10 % unterscheidet.

Es ist eine Aufgabe der vorliegenden Erfindung, Optiken eines Metrologiesystems an die bei der Projektionsbelichtung zur Herstellung von Halbleiterbauelementen vorliegenden Beleuchtungs- und Abbildungsverhältnisse anzupassen.

Diese Aufgabe wird erfindungsgemäß gelöst durch eine Beleuchtungsoptik nach Anspruch 1, durch eine abbildende Optik nach Anspruch 3 sowie durch ein Metrologiesystem nach den Ansprüchen 9 und 10.

Erfindungsgemäß wurde erkannt, dass eine Objektuntersuchung dann besonders wertvoll ist, wenn sie unter optischen Verhältnissen geschieht, die denen späterer Einsatzverhältnisse des zu untersuchenden Objekts möglichst gut angepasst sind. Bei den zu untersuchenden Objekten handelt es sich regelmäßig um Lithografiemasken, insbesondere um Retikel. Bei der Herstellung von Halbleiterbauelementen, insbesondere von Mikrochips, unter Verwendung derartiger Lithografiemasken können anamorphotische Projektionsoptiken, insbesondere mit unterschiedlichen Abbildungsfaktoren in zueinander senkrechten Richtungen, zum Einsatz kommen, für die eine entsprechend angepasste anamorphotische Beleuchtung, also eine Beleuchtung, die an eine nachfolgende anamorphotische Projektionsoptik mit unterschiedlichen Abbildungsfaktoren bzw. Abbildungsmaßstäben in zueinander senkrechten Richtungen, angepasst ist, erfolgt. Die erfindungsgemäßen Optiken erlauben eine optimale Anpassung der optischen Verhältnisse im Metrologiesystem an die bei der Projektionsbelichtung bei der Herstellung von Halbleiterbauelementen vorherrschenden Verhältnisse. Die Blendendurchmesser der Beleuchtungs-Aperturblende können sich um mehr als 20 %, um mehr als 50 %, um mehr als 75 %, um 100 %, um mehr als 100 %, um 150 %, um mehr als 150 % oder auch um einen noch größeren Verhältnisfaktor unterscheiden. Durch die Beleuchtungs-Aperturblende kann eine Verteilung einfallender Beleuchtungswinkel insbesondere einer anamorphotischen Beleuchtung eingestellt werden.

Eine Beleuchtungsoptik nach Anspruch 2 ist besonders gut an die Beleuchtungsverhältnisse bei der anamorphotischen Projektionsbelichtung bei der Herstellung von Halbleiterbauelementen angepasst.

Entsprechendes gilt für eine abbildende Optik nach den Ansprüchen 3 und 4. Die Abbildungs-Aperturblende mit den verschiedenen Blendendurchmessern sorgt dafür, dass ein Beschnitt eines Beugungsspektrum des abzubildenden Objekts korrekt für eine anamorphotische Projektionsoptik emuliert wird, wobei die abbildende Optik des Metrologiesystems selbst nicht anamorphotisch zu sein braucht.

Eine Abbildungs-Obskurationsblende nach Anspruch 5 ermöglicht eine Anpassung an die optischen Verhältnisse bei der Verwendung einer obskurierten Projektionsoptik der Projektionsbelichtung bei der Herstellung eines Halbleiterbauelements. Aperturblendenformen nach den Ansprüchen 6 und 7 haben sich zur Anpassung an die Verhältnisse bei der Projektionsbelichtung als besonders geeignet herausgestellt. Es kann die Beleuchtungs-Aperturblende und/oder die Abbildungs-Aperturblende elliptisch ausgeführt sein. Auch ein anderes Blendendurchmesserverhältnis als ein 2:1-Durchmesserverhältnis der Blendendurchmesser ist möglich, beispielsweise ein kleineres Durchmesserverhältnis, z. B. kleiner als 2:1, 1,8:1, 1,6:1, 1,5:1 oder ein noch kleineres Durchmesserverhältnis, wie beispielsweise 1,2:1, 1,1:1 oder noch kleiner, oder auch ein größeres Durchmesserverhältnis, z. B. größer als 2:1, 2,5:1, 3:1, 4:1, 5:1, 8:1, 10:1 oder ein noch größeres Durchmesserverhältnis.

Ein Blenden-Verlagerungsantrieb nach Anspruch 8 erlaubt eine feine Anpassung an vorzugebende Abbildungsverhältnisse. Mit dem Blenden-Verlagerungsantrieb können beide Blendendurchmesser in vorgegebener Weise veränderbar sein. Die Beleuchtungs-Aperturblende und/oder die Abbildungs-Aperturblende können mit einem derartigen Blenden-Verlagerungsantrieb ausgerüstet sein. Soweit beide Aperturblenden jeweils mit einem Verlagerungsantrieb ausgerüstet sind, können diese Verlagerungsantriebe in miteinander gekoppelter bzw. synchronisierter Weise oder auch unabhängig voneinander angesteuert sein. Als Verlagerungsantrieb oder anstelle eines Verlagerungsantriebs kann ein Blendenwechsler zum Austausch der jeweiligen Aperturblende gegen eine Wechsel-Aperturblende zum Einsatz kommen.

Die Vorteile eines Metrologiesystems mit einer derartigen Beleuchtungsoptik bzw. mit einer derartigen abbildenden Optik entsprechen denen, die vorstehend bereits erläutert wurden. Ein derartiges Metrologiesystem kann auch gleichzeitig eine erfindungsgemäße Beleuchtungsoptik und eine erfindungsgemäße abbildende Optik beinhalten.

Eine Detektionseinrichtung nach Anspruch 11 erlaubt eine nachträgliche Beeinflussung insbesondere digitaler Bilddaten, die mit der Detektionseinrichtung erzeugt werden. Eine derartige Beeinflussung kann beispielsweise mit Hilfe eines Bild-Streckungsfaktors geschehen, der in einer Dimension senkrecht zu einer Einfallsebene des Beleuchtungslichts auf dem Objekt anders ist als parallel dazu. Insbesondere kann diese digitale Streckung oder Stauchung des Bildes auf das Verhältnis der Blendendurchmesser abgestimmt sein. Dies ermöglicht es, mit einem Metrologiesystem, das eine nicht-anamorphotische abbildende Optik aufweist, eine anamorphotische Projektionsoptik einer Projektionsbelichtungsanlage zur Herstellung von Halbleiterbauelementen zu emulieren.

Ein Ausführungsbeispiel der Erfindung wird nachfolgend anhand der Zeichnung näher erläutert. In dieser zeigen:
- Fig. 1: stark schematisch in einer Aufsicht mit Blickrichtung senkrecht zu einer Einfallsebene ein Metrologiesystem für die Untersuchung eines Objekts mit EUV-Beleuchtungs- und Abbildungslicht mit einer Beleuchtungsoptik und einer abbildenden Optik, die jeweils sehr stark schematisch dargestellt sind;
- Fig. 2: ein Beleuchtungssetting, also eine Intensitätsverteilung von Beleuchtungslicht in einer Pupillenebene der Beleuchtungsoptik, für eine Beleuchtung des Objekts;
- Fig. 3: eine Aufsicht auf das abzubildende Objekt;
- Fig. 4: eine Aufsicht auf eine Abbildungs-Aperturblende zur randseitigen Begrenzung eines Abbildungslichtbündels in der abbildenden Optik; und
- Fig. 5: eine Abbildungslicht-Intensitätsverteilung in einer Bildebene der abbildenden Optik, gemessen von einer Detektionseinrichtung des Metrologiesystems.

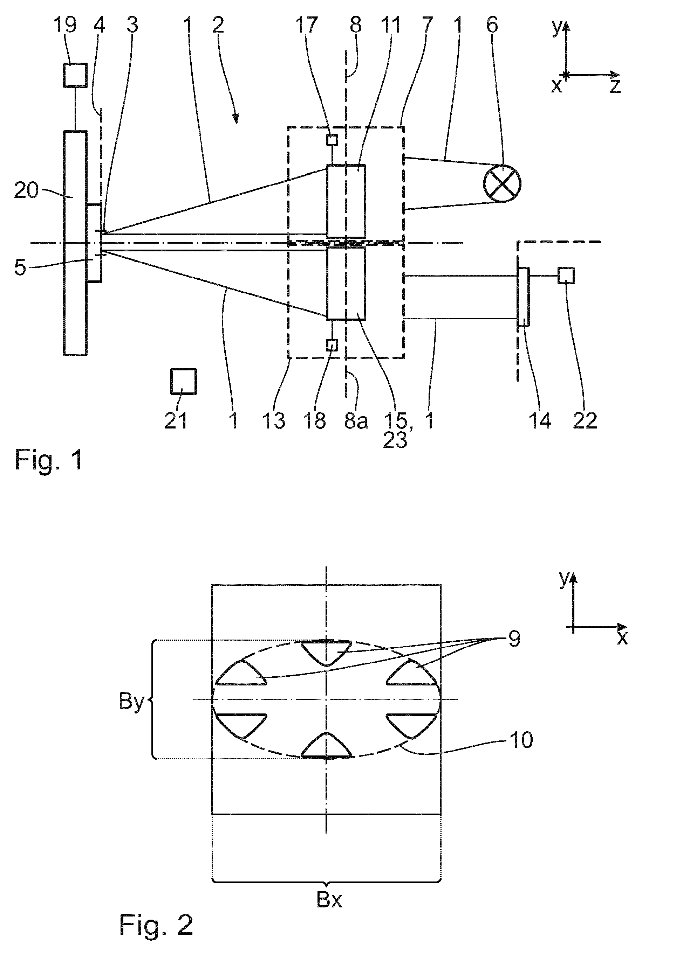

Zur Erleichterung der Darstellung von Lagebeziehungen wird nachfolgend ein kartesisches xyz-Koordinatensystem verwendet. Die x-Achse verläuft in der Figur 1 senkrecht zur Zeichenebene in diese hinein. Die y-Achse verläuft in der Figur 1 nach oben. Die z-Achse verläuft in der Figur 1 nach rechts.

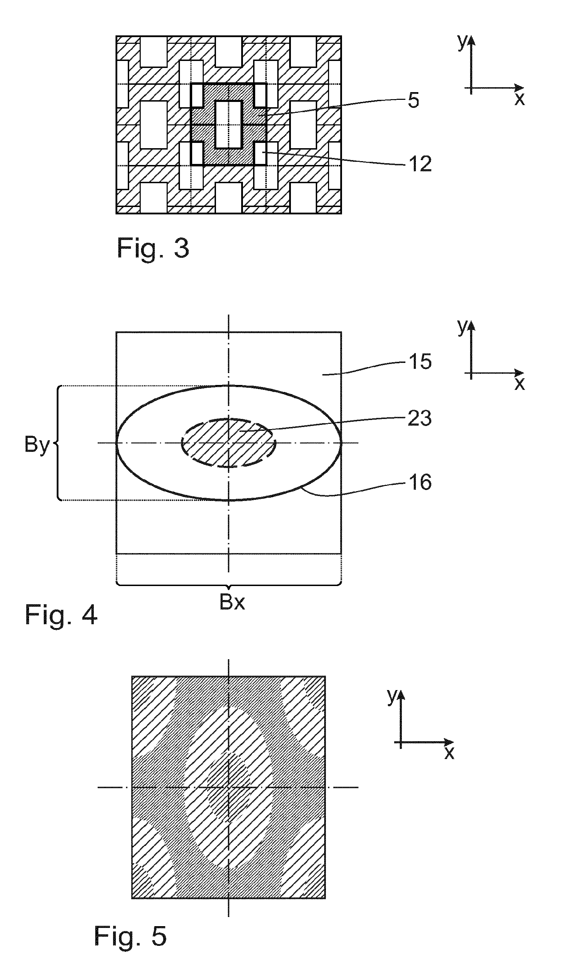

Figur 1 zeigt in einer einem Meridionalschnitt entsprechenden Ansicht einen Strahlengang von EUV-Beleuchtungslicht bzw. Abbildungslicht 1 in einem Metrologiesystem 2 für die Untersuchung eines in einem Objektfeld 3 in einer Objektebene 4 angeordneten Objekts 5 in Form eines Retikels bzw. einer Lithografiemaske mit dem EUV-Beleuchtungslicht 1. Das Metrologiesystem 2 wird zur Analyse eines sogenannten Luftbildes (Aerial Image Metrology System) eingesetzt und dient zur Simulation und Analyse der Auswirkungen von Eigenschaften von Lithographiemasken, sogenannten Retikels, die wiederum bei der Projektionsbelichtung zur Herstellung von Halbleiterbauelementen zum Einsatz kommen, auf die optische Abbildung durch Projektionsoptiken innerhalb einer Projektionsbelichtungsanlage. Derartige Systeme sind aus der US 2013/0063716 A1 (vgl. dort Figur 3), aus der DE 102 20 815 A1 (vgl. dort Figur 9) und aus der DE 102 20 816 A1 (vgl. dort Figur 2) und aus der US 2013/0083321 A1 bekannt.

Das Beleuchtungslicht 1 wird am Objekt 5 reflektiert. Eine Einfallsebene des Beleuchtungslichts 1 liegt parallel zur y-z-Ebene.

Das EUV-Beleuchtungslicht 1 wird von einer EUV-Lichtquelle 6 erzeugt. Bei der Lichtquelle 6 kann es sich um eine Laser-Plasma-Quelle (LPP; laser produced plasma) oder um eine Entladungsquelle (DPP; discharge produced plasma) handeln. Grundsätzlich kann auch eine Synchrotron-basierende Lichtquelle zum Einsatz kommen, z. B. ein Freie-Elektronen-Laser (FEL).

Zwischen der Lichtquelle 6 und dem Objekt 5 ist eine Beleuchtungsoptik 7 des Metrologiesystems 2 angeordnet. Die Beleuchtungsoptik 7 dient zur Beleuchtung des zu untersuchenden Objekts 5 mit einer definierten Beleuchtungsintensitätsverteilung über das Objektfeld 3 und gleichzeitig mit einer definierten Beleuchtungswinkelverteilung, mit der die Feldpunkte des Objektfeldes 3 beleuchtet werden.

Figur 2 zeigt ein entsprechendes Beleuchtungssetting, welches für die Beleuchtungsoptik 7 einstellbar ist. Dargestellt ist in der Figur 2 eine Intensitätsverteilung des Beleuchtungslichts 1 in einer Pupillenebene 8 (vgl. Figur 1) bzw. in einer hierzu konjugierten Ebene der Beleuchtungsoptik 7. Das Beleuchtungssetting ist beispielhaft als Hexapol-Setting mit sechs Beleuchtungspolen 9 ausgestaltet.

Die sechs Beleuchtungspole 9 liegen innerhalb einer elliptischen äußeren Randkontur 10, die in der Figur 2 gestrichelt angedeutet ist. Diese Randkontur 10 folgt einer Ellipse mit einem Verhältnis zwischen großer Halbachse parallel zur x-Achse und kleiner Halbachse parallel zur y-Achse von 2:1. Auch andere Achsenverhältnisse der elliptischen Randkontur 10 im Bereich von 10:1 und 1,1:1 sind möglich, beispielsweise von 1,5:1, 1,6:1, 2,5:1,3:1,4:1,5:1 oder 8:1.

Die elliptische Randkontur 10 wird von einer Beleuchtungs-Aperturblende 11 der Beleuchtungsoptik 7 erzeugt, die ein auf die Beleuchtungs-Aperturblende 11 einfallendes Bündel des Beleuchtungslichts 1 randseitig begrenzt. Entsprechend weist die Beleuchtungs-Aperturblende 11 in einer sich parallel zur xy-Ebene erstreckenden Blendenebene in den zwei zueinander senkrechten Richtungen x und y zwei sich voneinander um mindestens 10 %, im vorliegenden Fall um 100 % unterscheidende Blendendurchmesser auf, deren Entsprechungen in der Figur 2 mit Bx und By bezeichnet sind. Den größeren Blendendurchmesser Bx hat die Beleuchtungs-Aperturblende 11 senkrecht zur Einfallsebene yz des Beleuchtungslichts 1 auf dem Objekt 5.

Das Metrologiesystem 2 ist zur Untersuchung an anamorphotischen Masken mit unterschiedlichen Struktur-Skalierungsfaktoren in x und y ausgelegt. Derartige Masken sind zur Herstellung von Halbleiterelementen mittels anamorphotischer Projektionsanlagen geeignet.

Eine numerische Apertur des Beleuchtungs- und Abbildungslichts 1 in der xz-Ebene kann retikelseitig bei 0,125 und in der yz-Ebene retikelseitig bei 0,0625 liegen.

Figur 3 zeigt eine Aufsicht auf das Objekt 5. Strukturen auf dem Retikel 5 sind in der y-Richtung um einen Faktor 2 gestreckt. Dies bedeutet, dass eine Teilstruktur, beispielsweise die Rechteck-Struktur 12 in der rechten unteren Ecke des Objekts 5 nach Figur 3, die in eine 1:1-Struktur abgebildet werden soll, ein x/y-Aspektverhältnis von 1:2 aufweist.

Nach Reflexion am Objekt 5 tritt das Beleuchtungs- bzw. Abbildungslicht 1 in eine abbildende Optik bzw. Projektionsoptik 13 des Metrologiesystems 2 ein, die in der Figur 1 ebenfalls schematisch durch eine gestrichelte Berandung angedeutet ist. Die abbildende Optik 13 dient zur Abbildung des Objekts 5 hin zu einer ortsauflösenden Detektionseinrichtung 14 des Metrologiesystems 2. Die Detektionseinrichtung 14 ist z.B. als CCD-Detektor ausgebildet.

Die abbildende Optik 13 umfasst eine im Strahlengang nach dem Objekt 5 angeordnete Abbildungs-Aperturblende 15 (vgl. auch Figur 4) zur randseitigen Begrenzung eines Abbildungslicht-Bündels. Die Abbildungs-Aperturblende 15 ist in einer Pupillenebene 8a der abbildenden Optik 13 angeordnet. Die Pupillenebenen 8 und 8a können zusammenfallen; dies ist allerdings nicht zwingend.

Die Abbildungs-Aperturblende 15 hat eine elliptische Randkontur 16 mit einem x/y-Halbachsenverhältnis von 2:1. Die Abbildungs-Aperturblende 15 hat also in einer sich parallel zur xy-Ebene erstreckenden Blendenebene in zwei zueinander senkrechten Richtungen x, y zwei sich voneinander um mindestens 10 % unterscheidende Blendendurchmesser, die in der Figur 4 wiederum mit Bx, By bezeichnet sind. Für das Durchmesserverhältnis Bx:By im Bereich zwischen 10:1 und 1,1:1 gilt, was vorstehend zum entsprechenden Durchmesserverhältnis der Beleuchtungs-Aperturblende 11 ausgeführt wurde.

Auch die Abbildungs-Aperturblende 15 hat den größeren Blendendurchmesser Bx senkrecht zur Einfallsebene yz des Beleuchtungs- bzw. Abbildungslichts 1 auf dem Objekt 5. Auch bei der Abbildungs-Aperturblende 15 ist der Durchmesser Bx doppelt so groß wie der Durchmesser By.

Die beiden Aperturblenden 11, 15 haben jeweils einen Blenden-Verlagerungsantrieb 17, 18, über den mindestens einer der beiden Bündeldurchmesser Bx, By in vorgegebener Weise veränderbar ist. Hierzu können die Aperturblenden 11, 15 nach Art von Irisblenden gestaltet sein. Die Blenden-Verlagerungsantriebe 17, 18 können voneinander unabhängig ausgeführt sein. Alternativ können die Blenden-Verlagerungsantriebe 17, 18 derart gekoppelt sein, dass die beiden Aperturblenden 11, 15 jeweils hinsichtlich ihres Blendendurchmesserverhältnisses synchronisiert verstellt werden. Das Blendendurchmesserverhältnis Bx/By kann stufenlos verstellbar sein.

Die Verlagerungsantriebe 17, 18, die Lichtquelle 6, die Detektionseinrichtung 14 sowie ein weiterer Verlagerungsantrieb 19, mit dem ein Objekthalter 20, der das Objekt 5 trägt, parallel zur xy-Ebene verlagert werden kann, werden von einer gemeinsamen Steuereinrichtung 21 gesteuert. Letztere steht mit den zu steuernden Komponenten in in der Figur 1 nicht näher dargestellten Weise in Signalverbindung.

Anstelle eines Verlagerungsantriebs 17 bzw. 18 kann auch ein Blendenwechsler eingesetzt sein, der eine Mehrzahl von Aperturblenden mit verschiedenen Blendendurchmesser-Verhältnissen Bx:By aufweist.

Durch die Verlagerungsantriebe 17, 18 bzw. durch die alternativ hierzu einsetzbaren Wechsler kann auch die Situation hergestellt werden, bei der eine oder beide der Aperturblenden 11, 15 mit einem Blendendurchmesserverhältnis Bx:By von 1:1 eingesetzt wird, also eine kreisrunde Aperturblende 11 bzw. 15. Das Metrologiesystem 2 kann dann auf Wunsch auch im konventionellen, nicht anamorphotischen Betrieb genutzt werden.

Figur 5 zeigt eine Intensitätsverteilung des Abbildungslichts 1 auf einem Sensor der Detektionseinrichtung 14. Diese Intensitätsverteilung stellt ein Bild des Objekts 5 dar.

Die Detektionseinrichtung 14 weist eine digitale Bildverarbeitungseinrichtung 22 auf, die ebenfalls mit der zentralen Steuereinrichtung 21 in Signalverbindung steht.

Bei der abbildenden Optik 13 kann es sich um eine Projektionsoptik mit Pupillenobskuration handeln. In diesem Fall hat die Projektionsoptik 13 noch zusätzlich eine Abbildungs-Obskurationsblende 23 zur Vorgabe einer inneren Obskurationsbegrenzung im Bündel des Abbildungslichts 1. Diese Abbildungs-Obskurationsblende 23 kann am Ort der Abbildungs-Apertur 15 angeordnet sein, wie in der Figur 4 gestrichelt angedeutet. Alternativ kann die Abbildungs-Obskurationsblende 23 auch im Bereich einer konjugierten Pupillenebene angeordnet sein, die zur Pupillenebene 8a, in der die Abbildungs-Aperturblende 15 angeordnet ist, konjugiert ist.

## Patentansprüche

1. Beleuchtungsoptik (7) für ein Metrologiesystem (2) für die Untersuchung eines Objekts (5) mit EUV-Beleuchtungs- und Abbildungslicht (1)
- mit einer im Strahlengang vor dem Objekt (5) angeordneten Beleuchtungs-Aperturblende (11) zur randseitigen Begrenzung eines Bündels des Beleuchtungslichts (1),
- wobei die Beleuchtungs-Aperturblende (11) in einer Blendenebene (xy) in zwei zueinander senkrechten Richtungen zwei sich voneinander um mindestens 10 % unterscheidende Blendendurchmesser (Bx, By) aufweist.

2. Beleuchtungsoptik nach Anspruch 1, **dadurch gekennzeichnet, dass** die Beleuchtungsoptik (7) für ein reflektierendes Objekt (5) ausgeführt ist, wobei die Beleuchtungs-Aperturblende (11) senkrecht zu einer Einfallsebene (y, z) des Beleuchtungslichts (1) auf dem Objekt (5) den größeren Blendendurchmesser (Bx) aufweist.

3. Abbildende Optik (13) für ein Metrologiesystem (2) für die Untersuchung eines Objekts (5) mit EUV-Beleuchtungs- und Abbildungslicht (1)
- mit einer im Strahlengang nach dem Objekt (5) angeordneten Abbildungs-Aperturblende (15) zur randseitigen Begrenzung eines Bündels des Abbildungslichts (1),
- wobei die Abbildungs-Aperturblende (15) in einer Blendenebene (xy) in zwei zueinander senkrechten Richtungen zwei sich voneinander um mindestens 10 % unterscheidende Blendendurchmesser (Bx, By) aufweist.

4. Abbildende Optik nach Anspruch 3, **dadurch gekennzeichnet, dass** die abbildende Optik (13) für ein reflektierendes Objekt (5) ausgeführt ist, wobei jede Abbildungs-Aperturblende (15) senkrecht zu einer Einfallsebene (y, z) des Abbildungslichts (1) auf dem Objekt (5) den größeren Blendendurchmesser (Bx) aufweist.

5. Abbildungsoptik nach Anspruch 3 und 4, **gekennzeichnet durch** eine im Strahlengang nach dem Objekt (5) angeordnete Abbildungs-Obskurationsblende (23) zur Vorgabe einer inneren Obskurationsbegrenzung im Bündel des Abbildungslichts (1).

6. Optik nach einem der Ansprüche 1 bis 5, **dadurch gekennzeichnet, dass** die Aperturblende (11; 15) elliptisch ausgeführt ist.

7. Optik nach einem der Ansprüche 1 bis 6, **dadurch gekennzeichnet, dass** der größere (Bx) der beiden Blendendurchmesser (Bx, By) doppelt so groß ist wie der kleinere (By) der beiden Blendendurchmesser (Bx, By).

8. Optik nach einem der Ansprüche 1 bis 7, **gekennzeichnet durch** einen BlendenVerlagerungsantrieb (17, 18), über den mindestens einer der beiden Blendendurchmesser (Bx, By) in vorgegebener Weise veränderbar ist.

9. Metrologiesystem (2) mit einer Beleuchtungsoptik nach einem der Ansprüche 1, 2 sowie 6 bis 8 zur Beleuchtung des zu untersuchenden Objekts (5) und mit einer abbildenden Optik (13) zur Abbildung eines Objekts (5) hin zu einer ortsauflösenden Detektionseinrichtung (14).

10. Metrologiesystem (2) mit einer abbildenden Optik (13) nach einem der Ansprüche 3 bis 8 zur Abbildung des Objekts (5) hin zu einer ortsauflösenden Detektionseinrichtung (14) und mit einer Beleuchtungsoptik (7) zur Beleuchtung des zu untersuchenden Objekts (5).

11. Metrologiesystem nach Anspruch 9 oder 10, **dadurch gekennzeichnet, dass** die Detektionseinrichtung (14) eine digitale Bildverarbeitungseinrichtung (22) aufweist.
